# EUROPÄISCHE PATENTANMELDUNG

(11) **EP 0 936 738 A1**
(43) Veröffentlichungstag der Anmeldung: **18.08.1999**
(21) Anmeldenummer: 98810116.8
(22) Anmeldetag: 13.02.1998
(51) Int. Cl.: H03K 17/95

(54) **Induktiver Näherungsschalter mit einem aus einem Stück bestehenden Gehäuse**

(71) Anmelder: Optosys SA, 1762 Givisiez (CH)
(72) Erfinder: Heimlicher, Peter, 1700 Freiburg (CH)
(74) Vertreter: AMMANN PATENTANWAELTE AG BERN

(57) **Zusammenfassung**

Induktiver Näherungsschalter mit einer Spule, Mitteln zum Speisen der Spule mit einem periodischen Sendestrom der Periode T und Mitteln zum Verarbeiten von Signalen, die induzierten Spannungen entsprechen, die nach dem Ende eines Sendestromimpulses durch den in dem zu erfassenden Körper fliessenden abklingenden Strom, der dort vorher infolge der durch die vom Sendestromimpuls induzierten Spannung fliesst, in der Spule induziert wird.

Zur Verbesserung der Robustheit des Näherungsschalters ist dieser dadurch gekennzeichnet, dass die Spule (12), die Mittel zum Speisen der Spule mit einem periodischen Sendestrom und die Mittel zum Verarbeiten von Signalen in einem zylindrischen, auf der Seite der aktiven Fläche (24) des Sensors abgeschlossenen Gehäuse (21) angeordnet sind, welches aus einem Metall besteht, das nicht ferromagnetisch ist und einen relativ hohen spezifischen elektrischen Widerstand aufweist.

## Beschreibung

Die Erfindung betrifft einen induktiven Näherungsschalter mit
- einer Spule,
- Mitteln zum Speisen der Spule mit einem periodischen Sendestrom der Periode T, und
- Mitteln zum Verarbeiten von Signalen, die induzierten Spannungen entsprechen, die nach dem Ende eines Sendestromimpulses durch den in dem zu erfassenden Körper fliessenden abklingenden Strom, der dort vorher infolge der durch die vom Sendestromimpuls induzierten Spannung fliesst, in der Spule induziert wird.

Ein Naherungsschalter der oben erwähnten Art ist aus der EP-A-0492029 B1 bekannt. Bei diesem Näherungsschalter wird die Spule 12 mit periodischen Sendestromimpulsen beaufschlagt. Als Nutzsignal wird mit einer geeigneten elektronischen Schaltung die Empfangsspannung erfasst, die nach dem Ende eines Sendestromimpulses durch den in dem zu erfassenden Körper fliessenden abklingenden Strom, der dort vorher infolge der durch die vom Sendestromimpuls induzierten Spannung fliesst, in der Spule 12 induziert wird.

In einer Weiterentwicklung des aus der EP-A-0492029 B1 bekannten Näherungsschalters wird die soeben erwähnte, in der Spule induzierten Spannung jeweils über ein relativ kurzes Zeitfenster integriert, um nach geeigneter Verarbeitung ein geglättetes Nutzsignal zu erhalten. Dieses Signal wird mit einer Referenzspannung verglichen, um ein Ausgangssignal zu erzeugen, welches das Vorhandensein eines zu erfassenden Körpers in der Nähe des Sensors signalisiert, falls sich ein solcher Körper dort befindet. Mit einem derartigen Sensor wird ein überdurchschnittlich guter Schaltabstand bei der Erfassung von metallischen Körpern, z. B. aus Aluminium oder Stahl, erzielt.

Die Komponenten bekannter Näherungsschalter, die nach dem in der EP-A-0492029 B1 beschriebenen Prinzip arbeiten, sind üblicherweise in einem aus zwei oder mehr Teilen bestehenden Gehäuse enthalten, das sich in der Regel zumindest aus einem länglichen, metallischen Zylinder und einer Kappe aus Kunststoff, welche die aktive Fläche 24, d. h. die Austrittsfläche des von der Spule erzeugten magnetischen Feldes, abschliesst, zusammensetzt. Ein solches Gehäuse ist für Anwendungen ungeeignet, bei denen der Sensor Schlägen auf die Kunststoffkappe, besonders aggressiven Umgebungen oder erhöhtem Umgebungsdruck ausgesetzt ist. Solche Umgebungsbedingungen machen ein sehr robustes Gehäuse erforderlich. Es ist insbesondere sehr schwierig zu erreichen, dass die Kappe des Sensors einen flüssigkeits- und gasdichten Verschluss des Zylinders bildet. Bei Verwendung eines üblichen Näherungsschalters in den genannten Umgebungen ist mit einer raschen Beschädigung der Komponenten des Sensors und daher mit einer relativ kurzen Lebensdauer desselben zu rechnen.

Der Erfindung liegt daher die Aufgabe zugrunde, einen induktiven Näherungsschalter der eingangs erwähnten Art bereitzustellen, der für den Einsatz bei mechanischer Beanspruchung der aktiven Fläche, in aggressiven Umgebungen und bei erhöhtem Umgebungsdruck geeignet ist, mit dem aber nach wie vor ein überdurchschnittlich guter Schaltabstand bei der Erfassung von metallischen Körpern, z. B. aus Aluminium oder Stahl, erzielbar ist.

Diese Aufgabe wird erfindungsgemäss mit einem induktiven Näherungsschalter der eingangs erwähnten Art gelöst, der durch die im kennzeichnenden Teil des Patentanspruchs 1 definierten Merkmale gekennzeichnet ist. Dank seiner Robustheit ist ein solcher Näherungsschalter sogar bei sehr anspruchsvollen Einsatzfällen bei sehr schwierigen Umgebungsbedingungen verwendbar, wobei die guten Eigenschaften des Sensors, insbesondere der damit erzielbare, überdurchschnittlich gute Schaltabstand bei der Erfassung von metallischen Körpern, z. B. aus Aluminium oder Stahl, beibehalten werden.

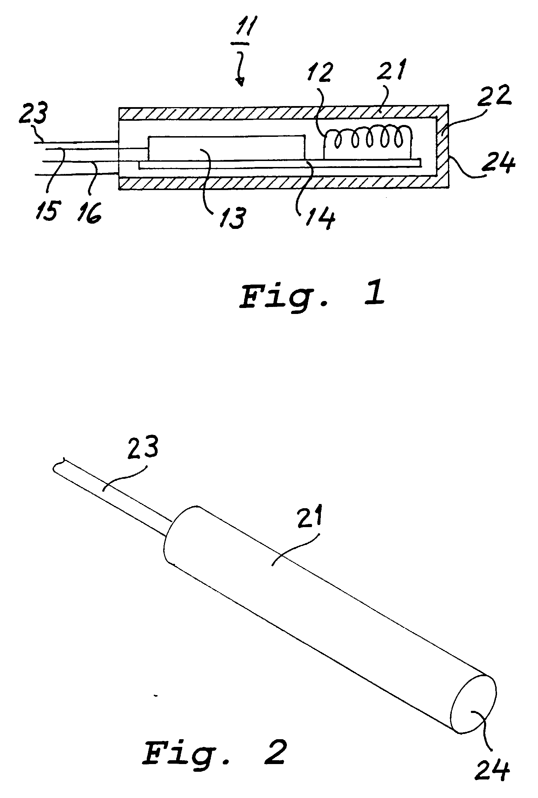

Ein Ausführungsbeispiel der Erfindung wird im folgenden anhand der beiliegenden Figuren 1 und 2 erläutert.
- Figur 1: zeigt einen schematischen Querschnitt eines erfindungsgemässen Näherungsschalters,
- Figur 2: zeigt eine perspektivische Ansicht des Näherungsschalters gemäss Fig. 1.

Wie in Fig. 1 schematisch dargestellt, enthält ein erfindungsgemässer Näherungsschalter 11 eine Spule 12 und eine elektronische Schaltung 13. Diese Schaltung 13 enthält Mittel zum Speisen der Spule mit einem periodischen Sendestrom der Periode T, die typischerweise zwischen 100 und 200 Mikrosekunden gewählt wird und Mittel zum Verarbeiten von Signalen, die induzierten Spannungen entsprechen, welche in der Spule entstehen, wenn ein zu erfassender Körper sich im Einflussbereich des variablen magnetischen Feldes befindet, das von der Spule aufgebaut wird, wenn diese mit dem periodischen Sendestrom gespiesen wird.

Die Spule 12 und die Schaltung 13 sind beispielsweise auf eine gedruckte Leiterplatte 14 montiert. Die elektronische Schaltung 13 ist über Leitungen 15 und 16 eines Kabels 23 mit dem Gerät oder System (nicht gezeigt) verbunden, in dem die mit dem Näherungsschalter 11 gewonnenen Signale weiterverarbeitet werden.

Wie aus Fig. 1 ersichtlich, sind alle Komponenten eines erfindungsgemässen Näherungsschalters in einem aus einem Stück bestehenden Gehäuse 21 angeordnet. Dieses Gehäuse umfasst auch den Abschluss 22 des Zylinders auf der Seite der aktiven Fläche 24 des Sensors. Dieser Abschluss 22 ersetzt die in bisher bekannten Ausführungen verwendete Kappe. Das Gehäuse besteht aus einem Metall, welches nicht ferromagnetisch ist und welches einen relativ hohen spezifischen elektrischen Widerstand aufweist, vorzugsweise aus nichtmagnetischem rostfreiem Stahl. Wegen dieser Eigenschaften entstehen in der aktiven Fläche 24 während des Betriebs des Näherungsschalters nur sehr kleine Wirbelströme, und die davon in der Spule 12 induzierten Spannungen sind im Messfenster des Nutzsignals vernachlässigbar klein. In zu erfassenden metallischen Körpern aus beispielsweise Stahl oder Aluminium entstehen hingegen wesentlich stärkere Wirbelströme, welche in der Spule Spannungen induzieren, die so stark sind, dass sie die Erfassung solcher Körper mit einem überdurchschnittlich grossen Schaltabstand ermöglichen.

Das Gehäuse 21 besteht vollständig aus Metall und bietet daher den Komponenten des Näherungsschalters 11 einen sehr guten Schutz gegen aggressive Umgebungen.

## Patentansprüche

1. Induktiver Näherungsschalter mit
- einer Spule,
- Mitteln zum Speisen der Spule mit einem periodischen Sendestrom der Periode T,
- Mitteln zum Verarbeiten von Signalen, die induzierten Spannungen entsprechen, die nach dem Ende eines Sendestromimpulses durch den in dem zu erfassenden Körper fliessenden abklingenden Strom, der dort vorher infolge der durch die vom Sendestromimpuls induzierten Spannung fliesst, in der Spule induziert wird,
welcher Näherungsschalter
dadurch gekennzeichnet ist, dass
die Spule (12), die Mittel zum Speisen der Spule mit einem periodischen Sendestrom und die Mittel zum Verarbeiten von Signalen in einem zylindrischen, auf der Seite der aktiven Fläche (24) des Sensors abgeschlossenen Gehäuse (21) angeordnet sind, welches aus einem Metall besteht, das nicht ferromagnetisch ist und einen relativ hohen spezifischen elektrischen Widerstand aufweist.

2. Induktiver Näherungsschalter gemäss Anspruch 1,
dadurch gekennzeichnet, dass das Gehäuse (21) aus einem Stück besteht.

3. Induktiver Näherungsschalter gemäss Anspruch 1,
dadurch gekennzeichnet, dass das Gehäuse (21) aus nichtmagnetischem rostfreiem Stahl besteht.
